# EUROPEAN PATENT APPLICATION

(11) **EP 4 518 593 A1**
(43) Date of publication of application: **05.03.2025**
(21) Application number: 23306447.6
(22) Date of filing: 31.08.2023
(51) Int. Cl.: H05K 7/14, F24F 5/00, H05K 7/20

(54) **MODULAR DATACENTER HAVING AN AIR-TO-LIQUID HEAT EXCHANGER**

(71) Applicant: OVH, 59100 Roubaix (FR)
(72) Inventor: CHEHADE, Ali, 59283 Moncheaux (FR); BAUCHART, Grégory Francis Louis, 59150 Wattrelos (FR)
(74) Representative: BCF Global

(57) **Abstract**

An air-to-liquid heat exchanger and modular datacenter including the same are disclosed. The air-to-liquid heat exchanger is configured to be disposed on a support surface and includes a frame, a heat exchanger panel mounted to the frame, and a fan assembly mounted to the frame. The heat exchanger panel extends substantially orthogonally to the support surface and is configured to circulate a channelized cooling liquid from a liquid inlet to a liquid outlet. The fan assembly includes at least one fan configured to pull ambient air through the heat exchanger panel, each of the at least one fan being rotatable about a rotation axis, the rotation axis extending substantially parallel to the support surface and at an angle with respect to a normal of the heat exchanger panel.

## Description

### FIELD OF TECHNOLOGY

The present technology relates to overall datacenter configurations, and in particular, to a modular datacenter configuration having an air-to-liquid heat exchanger.

### BACKGROUND

In efforts to process vast amounts of data in near-real time, permanent datacenters house and service multitudes of racks containing electronic equipment, such as, computer server assemblies, specialized processors, memory components, high-speed network modules, *etc.* as well as supporting infrastructure equipment, such as, power facilities, air handling systems, liquid cooling structures, *etc.*

The market demand to service the ever-increasing data processing requirements eventually leads to the need of more datacenters. However, the initial investment costs along with the construction time associated with the installation of permanent datacenters can be prohibitive.

To counter the high cost of constructing permanent datacenters, various solutions have been proposed directed to the installation of "modular datacenters," in which datacenter electronic computing equipment and supporting infrastructure equipment are incorporated in movable trailers or shipping containers. Depending on data processing demands, multiple trailers/shipping containers may be deployed and arranged in different single level geometric configurations that spread across a sizeable area. Therefore, in contrast to permanent datacenters, modular datacenters provide substantial reductions in overall construction time and installation costs to provide speedier turn-key operations.

However, a situation may exist in which certain space-limited geographical areas having high data processing needs (*e.g*., urban areas, research campuses, *etc*.), may not be able to accommodate sprawling modular datacenter configurations. It may, therefore, be desirable to provide multiple modular datacenter configurations having smaller footprints.

It is to be noted that the subject matter discussed in the background section should not be assumed to be prior art merely as a result of its mention in the background section. Similarly, the issues mentioned in the background section should not be interpreted as having been recognized in the prior art.

### SUMMARY

It is an object of the present technology to ameliorate at least some of the inconveniences of the prior art.

According to one aspect of the present technology, there is provided an air-to-liquid heat exchanger configured to be disposed on a support surface. The air-to-liquid heat exchanger includes a frame, a heat exchanger panel mounted to the frame, the heat exchanger panel being configured to circulate a channelized cooling liquid from a liquid inlet to a liquid outlet, the heat exchanger panel extending substantially orthogonally to the support surface and a fan assembly mounted to the frame. The fan assembly includes at least one fan configured to pull ambient air through the heat exchanger panel, each of the at least one fan being rotatable about a rotation axis, the rotation axis extending substantially parallel to the support surface and at an angle with respect to a normal of the heat exchanger panel.

Broadly speaking, the developers of the present technology have devised a modular datacenter that includes an air-to-liquid heat exchanger that is relatively accessible for maintenance, without requiring a human operator to use a forklift, or any other lifting apparatus. The human operator may directly access component of the air-to-liquid heat exchanger, thereby reducing costs and time resources required for maintenance.

In some non-limiting implementations, the frame defines a plurality of edges, the at least one fan is disposed along a first one of the plurality of edges.

In some non-limiting implementations, the fan assembly further comprises an air deflector configured to convey the ambient air from the heat exchanger panel to the at least one fan.

In some non-limiting implementations, the air deflector extends from a second one of the plurality of edges opposed to the first edge to the fan assembly.

In some non-limiting implementations, the angle is between 45° and 90°.

In some non-limiting implementations, the air deflector has a triangular shape.

In some non-limiting implementations, the angle is between 50° and 60°, a ratio of a distance between the first and second edges over a length of the deflector is between 1,1 and 1,2.

In a second broad aspect, there is provided an air cooling assembly includes a first air-to-liquid heat exchanger according to some implementations of the present technology and a second air-to-liquid heat exchanger according to some implementations of the present technology, the second air-to-liquid heat exchanger being disposed in a side-by-side configuration with the first air-to-liquid heat exchanger such that the heat exchanger panels of the first and second air-to-liquid heat exchangers are parallel and face a same direction. An intake area of the second air-to-liquid heat exchanger for pulling ambient air by the at least one fan thereof is distinct from an exhaustion area of the at least one fan of the first air-to-liquid heat exchanger.

In a third broad aspect of the present technology, there is provided a modular datacenter including a containment unit configured to house electronic devices, a pad structure platform mounted on a top surface of the containment unit and an air-to-liquid heat exchanger according to some implementations of the present technology. The air-to-liquid heat exchanger is mounted on the pad structure platform and cools channelized cooling liquid by discharging thermal energy thereof into a vicinity of an outside of the containment unit. The pad structure platform permits circulation of a human operator along a circulation path, the circulation path extending along at least a portion of the fan assembly and at least a portion of the heat exchanger panel air-to-liquid heat exchanger.

In some non-limiting implementations, the pad structure platform occupies a first surface area on the top surface of the containment unit, and the air-to-liquid heat exchanger occupying a second surface area on the pad structure platform, a size the second surface being smaller than a size of the first surface area.

In some non-limiting implementations, the heat exchanger panel is parallel to a longitudinal side of the containment unit.

In some non-limiting implementations, the first surface area is smaller than a surface of the top surface.

In some non-limiting implementations, the containment unit defines an opening on a top portion of thereof, and the pad structure platform further comprises a locking mechanism configured to engage said opening to secure the pad structure platform to the containment unit.

In some non-limiting implementations, the pad structure platform further comprises one or more sets of tilting plate members disposed therebelow, the tilting plate members of a same set being stacked upon one another being configured to raise a lateral side of the pad structure platform with respect to the top surface of the containment unit.

In some non-limiting implementations, the one or more sets of tilting plate members are disposed along longitudinal sides of the pad structure platform.

In some non-limiting implementations, the electronic devices are servers.

In some non-limiting implementations, the modular datacenter further includes a cooling loop for cooling the electronic devices, the cooling loop comprising cooling liquid units in thermal contact with the electronic devices for transferring thermal energy generated by the electronic devices to a channelized cooling liquid flowing in the cooling loop.

In some non-limiting implementations, the containment unit is a first containment unit, the electronic devices are first electronic devices, the cooling loop is a first cooling loop, the pad structure platform is a first pad structure platform and the air-to-liquid heat exchanger is a first air-to-liquid heat exchanger. The modular datacenter further includes a second containment unit disposed next to the first containment unit, the second containment unit being configured to house second electronic devices, a second cooling loop for cooling the second electronic devices, the cooling loop comprising cooling liquid units in thermal contact with the electronic devices for transferring thermal energy generated by the electronic devices to a channelized cooling liquid flowing in the cooling loop, a second pad structure platform mounted on a top surface of the second containment unit, the second pad structure platform occupying a third surface area on the top surface of the second containment unit and a second air-to-liquid heat exchanger according to any one of claims 1 to 7, mounted on the second pad structure platform and configured to cool the channelized cooling liquid by discharging thermal energy thereof into a vicinity of an outside of the second containment unit, the second air-to-liquid heat exchanger occupying a fourth surface area on the second pad structure platform, a size the fourth surface being smaller than a size of the third surface area, the second pad structure platform being configured to permit circulation of a human operator around at least a portion of the second air-to-liquid heat exchanger. The first and second pad structure platforms are configured to enable passage of the human operator from the first pad structure platform to the second pad structure platform.

In some non-limiting implementations, the first and second containment unit are disposed next to one another along longitudinal sides thereof.

In some non-limiting implementations, the first and second pad structure platforms respectively include a first fence defining a first door and a second fence defining a second door, the first and second doors being, in use, aligned with one another to face one another, the first and second doors being selectively open or close to enable passage of the human operator.

In the context of the present specification, unless expressly provided otherwise, a computer system may refer, but is not limited to, an "electronic device", an "operation system", a "system", a "computer-based system", a "controller unit", a "monitoring device", a "control device" and/or any combination thereof appropriate to the relevant task at hand.

In the context of the present specification, unless expressly provided otherwise, the expression "computer-readable medium" and "memory" are intended to include media of any nature and kind whatsoever, non-limiting examples of which include RAM, ROM, disks (CD-ROMs, DVDs, floppy disks, hard disk drives, etc.), USB keys, flash memory cards, solid state-drives, and tape drives. Still in the context of the present specification, "a" computer-readable medium and "the" computer-readable medium should not be construed as being the same computer-readable medium. To the contrary, and whenever appropriate, "a" computer-readable medium and "the" computer-readable medium may also be construed as a first computer-readable medium and a second computer-readable medium.

In the context of the present specification, unless expressly provided otherwise, the words "first", "second", "third", etc. have been used as adjectives only for the purpose of allowing for distinction between the nouns that they modify from one another, and not for the purpose of describing any particular relationship between those nouns.

Implementations of the present technology each have at least one of the above-mentioned object and/or aspects, but do not necessarily have all of them. It should be understood that some aspects of the present technology that have resulted from attempting to attain the above-mentioned object may not satisfy this object and/or may satisfy other objects not specifically recited herein.

Additional and/or alternative features, aspects and advantages of implementations of the present technology will become apparent from the following description, the accompanying drawings and the appended claims.

### BRIEF DESCRIPTION OF THE DRAWINGS

These and other features, aspects and advantages of the present technology will become better understood with regard to the following description, appended claims and accompanying drawings where:
Figure 1 is a perspective view of a modular datacenter according to non-limiting implementations of the present technology;
Figure 2 is a perspective view of a containment unit of the modular datacenter of Figure 1;
Figure 3 is a top view of an air-to-liquid heat exchanger of the modular datacenter of Figure 1;
Figure 6 is a perspective view of the air-to-liquid heat exchanger of the modular datacenter of Figure 1;

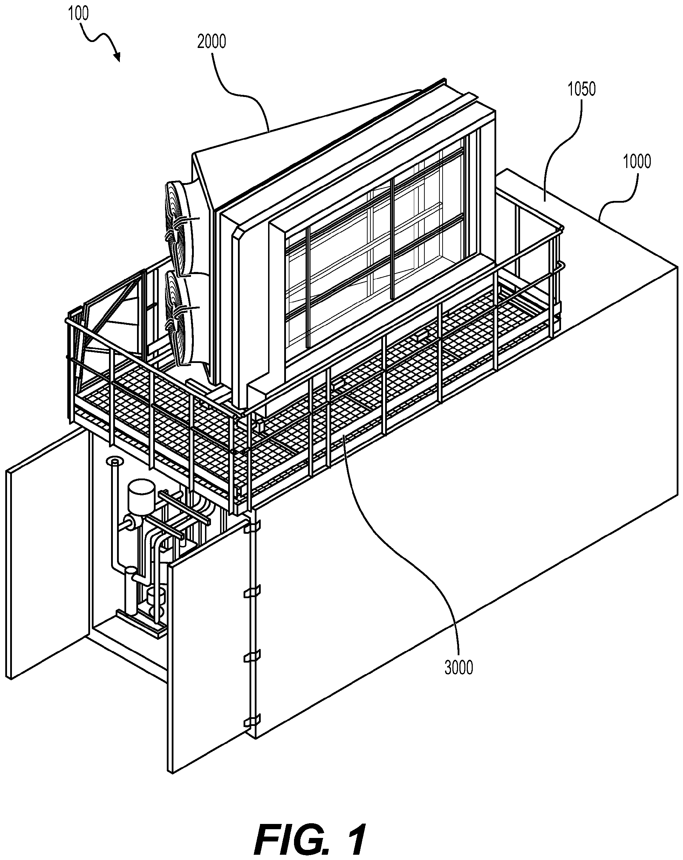

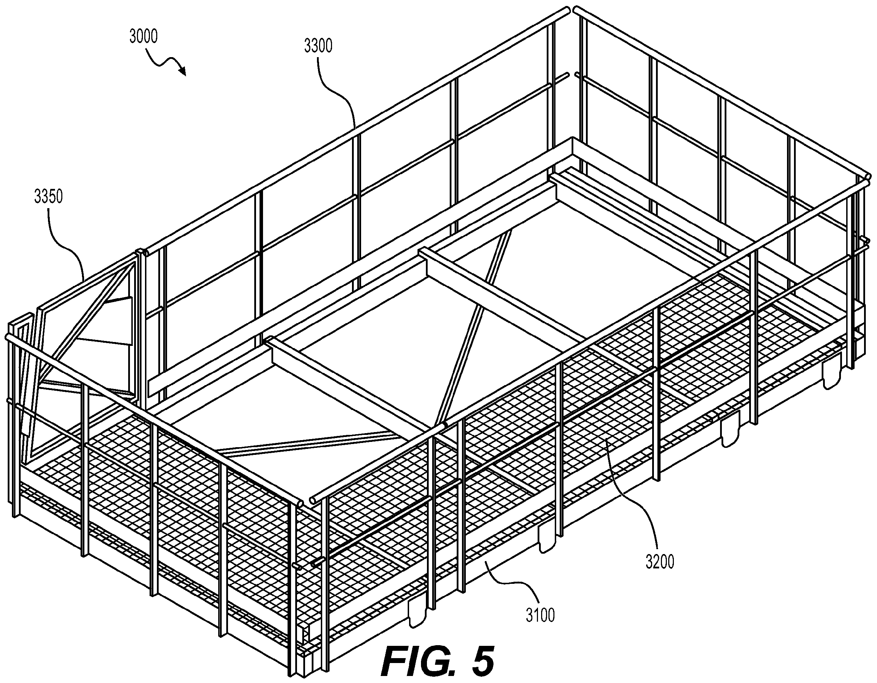

Figure 5 is a perspective view of a pad structure platform of the modular datacenter of Figure 1;

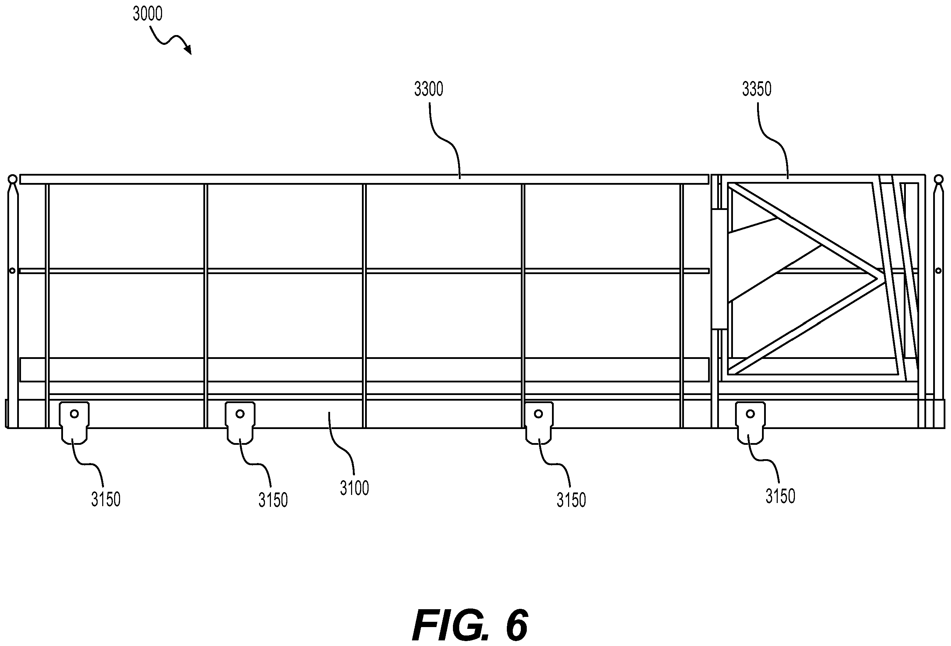

Figure 6 is a side view of the pad structure platform of Figure 5;

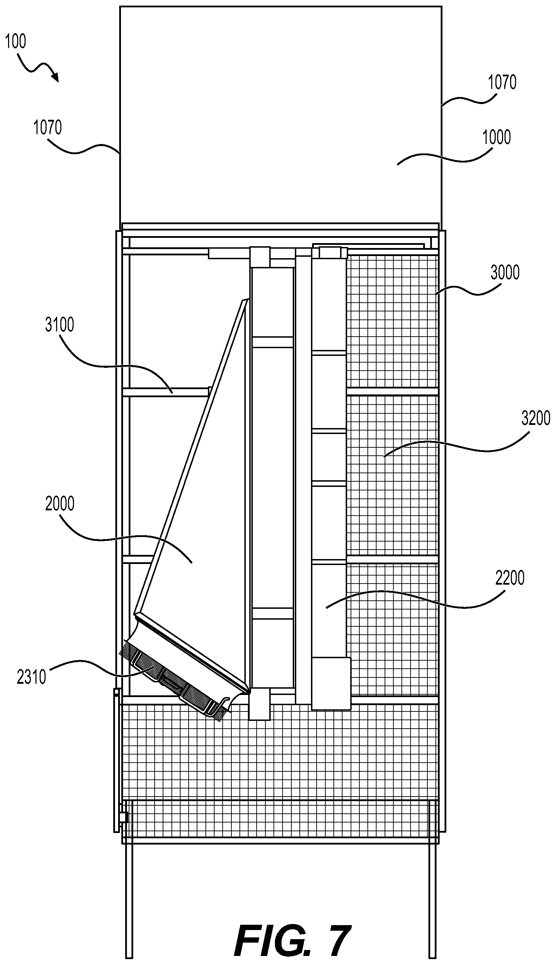

Figure 7 is a top view of the modular datacenter of Figure 1;

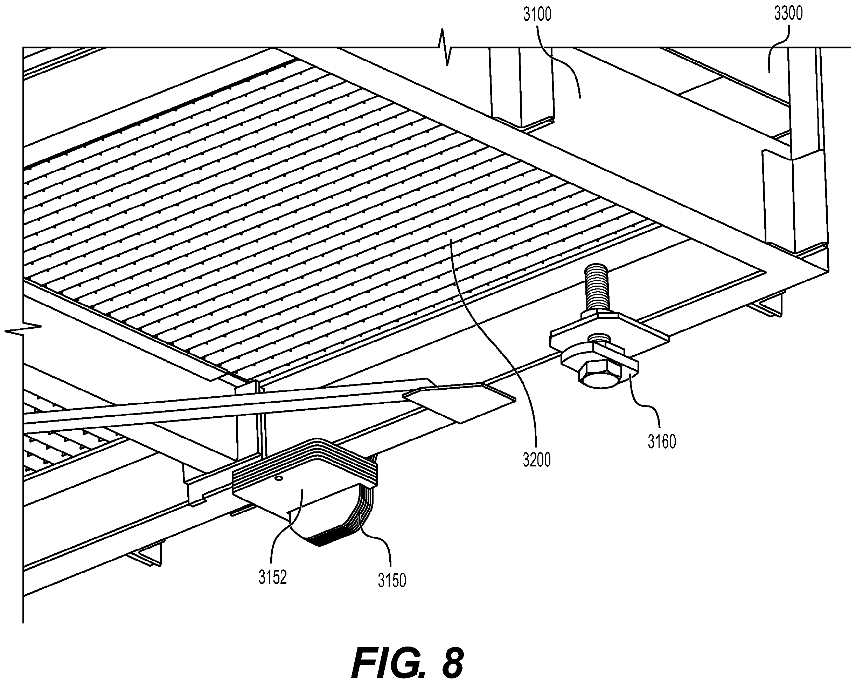

Figure 8 is a perspective view taken from a bottom of the pad structure platform of Figure 5; and

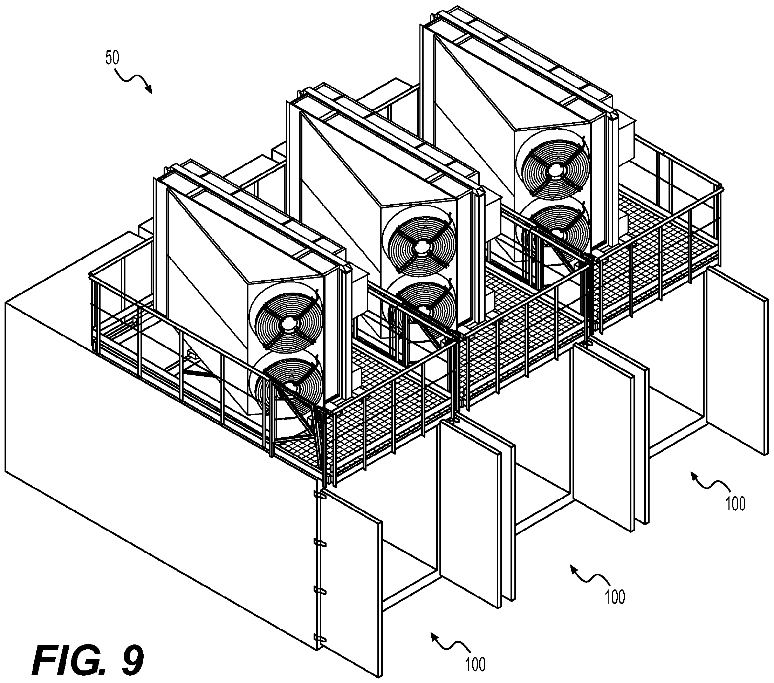

Figure 9 is a perspective view of an extended modular datacenter according to non-limiting implementations of the present technology.

It should also be noted that, unless otherwise explicitly specified herein, the drawings are not to scale.

### DETAILED DESCRIPTION

The examples and conditional language recited herein are principally intended to aid the reader in understanding the principles of the present technology and not to limit its scope to such specifically recited examples and conditions. It will be appreciated that those skilled in the art may devise various arrangements that, although not explicitly described or shown herein, nonetheless embody the principles of the present technology.

Furthermore, as an aid to understanding, the following description may describe relatively simplified implementations of the present technology. As persons skilled in the art would understand, various implementations of the present technology may be of a greater complexity.

In some cases, what are believed to be helpful examples of modifications to the present technology may also be set forth. This is done merely as an aid to understanding, and, again, not to define the scope or set forth the bounds of the present technology. These modifications are not an exhaustive list, and a person skilled in the art may make other modifications while nonetheless remaining within the scope of the present technology. Further, where no examples of modifications have been set forth, it should not be interpreted that no modifications are possible and/or that what is described is the sole manner of implementing that element of the present technology.

Moreover, all statements herein reciting principles, aspects, and implementations of the present technology, as well as specific examples thereof, are intended to encompass both structural and functional equivalents thereof, whether they are currently known or developed in the future. Thus, for example, it will be appreciated by those skilled in the art that any block diagrams herein represent conceptual views of illustrative systems embodying the principles of the present technology.

Figure 1 is a perspective view of a modular datacenter 100 including a containment unit 1000, a pad structure platform 3000 mounted on a top surface 1050 thereof, and an air-to-liquid heat exchanger 2000 mounted onto the pad structure platform 3000. The containment unit 1000 may be embodied by trailers, shipping containers, or other similarly-configured structures. In use, the containment unit 1100 houses and services an assembly of multiple racks containing electronic equipment, such as, computer server assemblies, specialized processors, memory components, high-speed network modules, along with supporting infrastructure equipment, such as, power facilities, air handling systems, liquid cooling structures, *etc.* It will be appreciated that the containment unit 1000 may incorporate different components and equipment of an overall modular datacenter system. The containment unit 1000 may incorporate one or more openings (not shown) to enable ventilation of the data processing equipment as well as accommodate the routing of associated cabling and/or piping arrangements to another containment unit and/or to external resources.

As will be described in greater details herein after, the containment unit 1000 houses electronic devices such as servers that may generate a significant amount of heat. Consequently, the modular datacenter 100 may use a cooling system to cool down the electronic devices to prevent the electronic devices from being damaged. For example, the cooling system of the modular datacenter 100 is a hybrid cooling system including an immersion cooling system and a channelized cooling system. It is contemplated that the cooling system of the modular datacenter 100 may be an immersion cooling system only or a channelized cooling system only.

As used herein, an immersion cooling system is a cooling system in which the electronic device is in direct contact with an immersive cooling liquid (e.g. a non-conductive cooling liquid), which either flows over at least portions of the electronic device, or in which at least portions of the electronic device are submerged. The immersive cooling liquid may be directly or indirectly cooled down using an air-to-liquid heat exchanger such as the air-to-liquid heat exchanger 2000.

As used herein, a channelized cooling system is a cooling system in which heat-generating components of the electronic device (i.e. electronic components thereof) or the dielectric cooling liquid are cooled using liquid cooling units, through which a channelized cooling liquid flow to collect thermal energy, which may also be called "cold plates" or "water blocks" (although the channelized cooling liquid circulating through the "water blocks" may be any of a wide variety of known thermal transfer liquids, rather than water). The channelized cooling liquid may be further cooled down using an air-to-liquid heat exchanger such as the air-to-liquid heat exchanger 2000. While in this example the channelized cooling liquid flowing in the closed loop may be water, the channelized cooling liquid may be a dielectric fluid, a refrigerant fluid, a diphasic fluid or any other fluid suitable for collecting and discharging thermal energy.

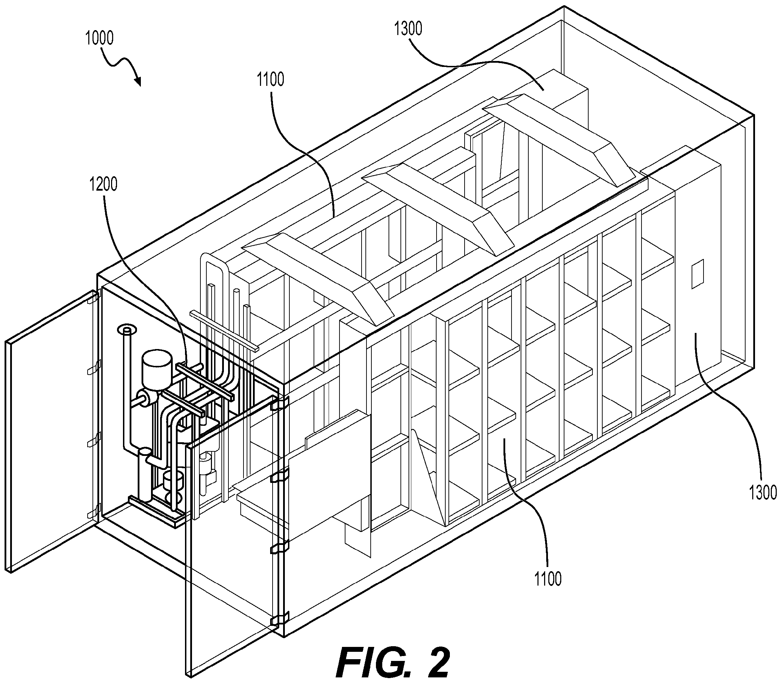

In any cases, the electronic devices of the modular datacenter 100 are cooled using a cooling liquid that extract thermal energy therefrom and is further cooled down by discharging said thermal energy into the ambient air using by the air-to-liquid heat exchanger 2000. For example, as depicted on Figure 2, the containment unit 1000 may include one or more rack systems 1100 (two of which being shown on Figure 2), a cooling module 1200 and electrical cabinets 1300.

More specifically, the rack systems 1100 may host a plurality of rack-mounted assemblies to be cooled and that includes the electronic devices to be cooled (e.g. servers). The cooling module 1200 may include pumps, piping assemblies, temperature sensors, liquid flow rate sensors, controllers and other data processing system for automation of the cooling of the electronic devices. In some implementations, each of the electrical cabinets 1300 may include routers, electrical power distribution units, power equipment, networking devices, fuses, sensors, data collecting devices, or any other suitable electrical components involved in proper operation of the modular datacenter 100.

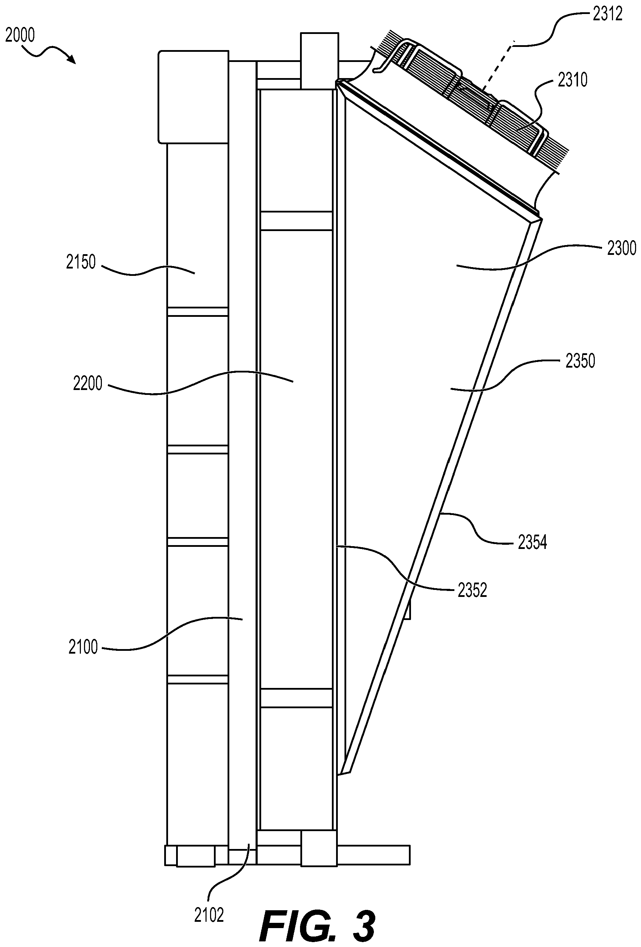

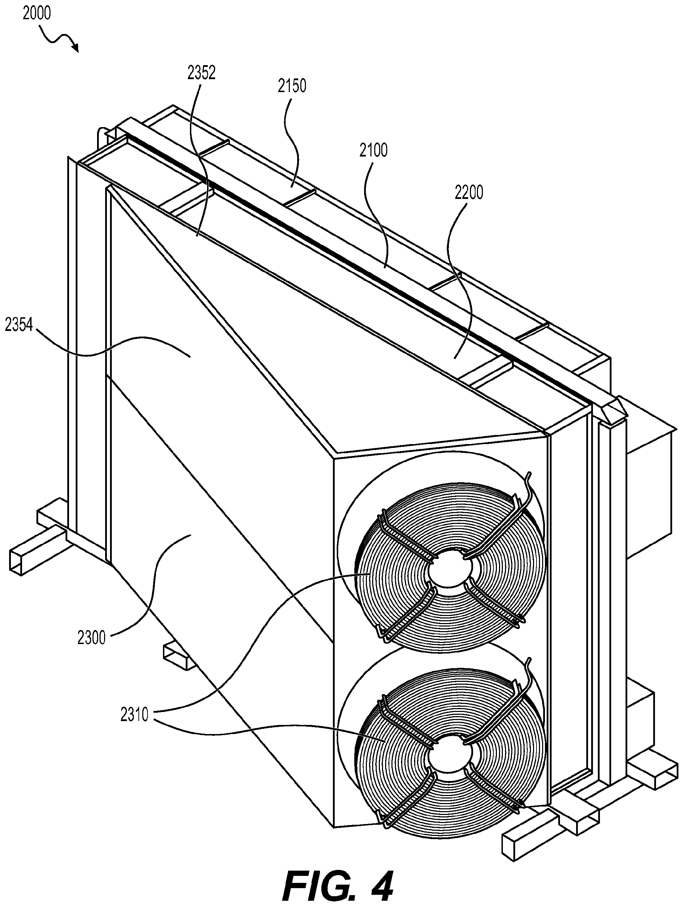

As shown on Figure 1 and with additional reference to Figure 3, the air-to-liquid heat exchanger 2000 extends substantially orthogonally to the top surface 1050 of the containment unit 1000. More specifically, the air-to-liquid heat exchanger 2000 includes a frame 2100 and a heat exchanger panel 2200 mounted to the frame 2100. In use, the heat exchanger panel 2200 discharges thermal energy of the channelized cooling liquid into the atmosphere. In this implementation, the frame 2100 has a rectangular shape thereby defining four edges. Other shapes of the frame 2100 having different number of edges are contemplated in alternative implementations of the present technology.

In particular, the heat exchanger panel 2200 is a liquid-to-air heat exchanger panel 2200 that transfers thermal energy from the channelized cooling liquid circulating therein to the air flowing therethrough. More specifically, the heat exchanger panel 2200 may have an air inlet side and an air outlet side through which, in use, air enters and exits the heat exchanger panel 2200 respectively.

The heat exchanger panel 2200 may include a cooling coil (not shown) for circulating the channelized cooling liquid therein and a plurality of fins (not shown) in thermal contact with the cooling coil. The cooling coil has an inlet and an outlet, as depicted in Figure 1, for feeding the channelized cooling liquid into and discharging the cooling liquid from the cooling coil. The fins may be spaced from one another for air to flow therebetween, from the air inlet side to the air outlet side of the heat exchanger panel 2200.

It is contemplated that the air-to-liquid heat exchanger 2000 may optionally include at least one cooling pad 2150 (see Figure 2), or evaporating pad, disposed on an exterior face of the heat exchanger 2000 and mounted to the frame 2100. In this implementation, the cooling pad 2150 is mounted on another side of the frame relatively to the heat exchanger panel 2200. With reference to Figure 3, the cooling pad 2150 is disposed on a lateral side of the heat exchanger 2000. An external cooling fluid may be dispensed across the cooling pad 2150, providing a cool surface. The ambient air is pulled through the cool surface of the cooling pad 2150, thereby cooling the ambient air prior to contact with the heat exchanger panel 2200. In use, the cooling fluid may be sprayed on the cooling pad 2150. The cooling fluid may be water, possibly with additives such as polyethylene glycol (PEG) and/or polypropylene glycol (PPG).

A distribution system may distribute the external cooling fluid in a surrounding environment of the air-to-liquid heat exchanger 2000, notably, in this example, onto the cooling pad 2150, such that ambient air flows through the wet cooling pad 2150. Temperature of ambient air flowing through the cooling pad 2150 thus decreases as a portion of the external cooling fluid (e.g. water droplets) distributed on the cooling pad 2150 evaporates. Thermal energy of the ambient air is thus absorbed by evaporation of the portion of the second cooling fluid such that the air flow's temperature is reduced. The cooling pad 2150 may be made of plastic material, cellulose, or glass fibers, but other materials are also contemplated in alternative embodiments.

The heat exchanger 2000 comprises a fan assembly 2300 that, in use, cause airflow through the heat exchanger 2000. The fan assembly 2300 is mounted to the frame 2100. In the context of the present disclosure, it is said that a component A is mounted to a component B when the component id directly or indirectly mounted to the component B. For example, the fan assembly 2300 may be mounted to the heat exchanger panel 2200 that is mounted to the frame 2100.

In particular, the fan assembly 2300 comprises a plurality of fans 2310 (only one can be seen on Figure 3). In this example, the fans 142 are rotatable about respective horizontal axes 2312 to pull ambient air into the air-to-liquid heat exchanger panel 2200. In this implementation, the rotation axis 2312 extends substantially horizontally, parallel to the top surface 1050 of the containment unit 1000, and at an angle with respect to a normal of the heat exchanger panel 2200. For example, said angle may be between 45° and 90°. In this implementation, said angle is between 50° and 60°. It can be said that the heat exchanger 200 has an angled configuration.

In this implementation, the fan assembly 2300 further includes an air deflector 2350 that conveys the ambient air from the heat exchanger panel 2200 to the fans 2310. More specifically, the air deflector 2350 extends from an edge 2102 of the frame 2100 (or an edge of the heat exchanger panel 2200) to the fans 2310 to convey heated air once the air has passed through the heat exchanger panel 2200.

As can be seen on Figure 3, the air deflector 2350 has a triangular shape having a first side 2352 extending along the heat-exchanger panel 2200 and a second side 2354 extending from the edge 2102 to the fans 2310. For example and without limitation, a ratio of the first side 2352 over the second side 2354 may be between 1,1 and 1,2.

The heat exchanger 2000 thus functions by pumping heated channelized cooling liquid extracted from the cooling units, in thermal contact with the electronic devices, through the cooling coils of the heat exchanger panel 2200, while simultaneously pulling ambient air between the fins and around the cooling coil of the heat exchanger panel 2200. The ambient air absorbs heat from the heated channelized cooling liquid circulating through the cooling coils. As ambient air is pulled in through the heat exchanger panel 2200 into an interior space of the heat exchanger 2000, thermal energy is transferred from the channelized cooling liquid circulating in the heat exchanger panel 2200 to the ambient air. The now-heated air is then discharged from the interior space of the heat exchanger 2000 through the fan assembly 2300. The channelized cooling liquid circulating in the heat exchanger panel 2200 is thus cooled and is recirculated back into the cooling loop to further collect thermal energy from the electronic devices for cooling thereof.

It will be appreciated that the configuration of the heat exchanger 2000 as described above is provided merely as an example to aid in understanding the present technology. The heat exchanger 2000 may be configured differently in other examples. For instance, a plurality of heat exchanger panels 20 may be provided, and the fan assembly 2300 may include a single fan 2310.

Figures 5 and 6 show the pad structure platform 3000 in accordance with some non-limiting implementations of the present technology. In use, the pad structure platform 3000 is mounted on a top surface 1050, or "roof surface" of the containment unit 1000 and support the heat exchanger 2000. More specifically, the pad structure platform 3000 includes a frame 3100, a platform 3200 mounted to the frame 3100 and a fence assembly 3300 mounted to the frame 3100 and extending along a periphery thereof.

As can be seen on Figure 5, the platform 3200 occupies a first portion of an area provided by the frame 3100, a second portion of said surface being occupied, in use, by the heat exchanger 2000. In this implementation, the platform 3200 is L-shaped. With additional reference to Figure 7, a human operator may thus navigate on the platform 3200 to access the heat exchanger 2000 and more precisely the fans 2310 and the heat exchanger panel 2200 without using a forklift or any lifting apparatus. Visual inspection and maintenance of the heat exchanger 200 by the human operator may thus be facilitated.

In this implementation, the fence assembly 2300 defines a guard door 3350 that can be selectively closed or open to allow the human operator to navigate from the platform 3200 to another platform mounted on another containment unit disposed adjacent to the containment unit 1000 (see Figure 9).

With reference to Figures 6 and 8, the pad structure platform 3000 further includes positioning plates 3150 extending from the frame 3100. The positioning plates 3150 may be for example mounted to the frame 3100. In use, the positioning plates 3150 are used to center the pad structure platform 3000 onto the top surface 1050 of the containment unit 1000. More specifically, the positioning plates 3150 may be in contact with external sides of lateral walls of the containment unit 1000 to prevent the pad structure platform 3000 from being misaligned with respect to the containment unit 1000.

In certain circumstances, a shape of the top surface 1050 may not be straight (e.g. the containment unit 1000 may have been damaged). It may therefore be advantageous to ensure that the pad structure platform 3000 is properly leveled to ease navigation of the human operators. In addition, the top surface 1050 of the containment unit 1000 may not be adapted to support a relatively high weight. It may therefore be advantageous to distribute the weight of the pad structure platform 3000 and the heat exchanger 2000 mounted thereon to load-bearing beams 1070 extending, in this implementation, along top portions of side walls of the containment unit 1000. For such purposes, tilting plates 3152 may be implemented and mounted to (e.g. slid along) any of the positioning plates 3150 to locally raise the frame 3100 with respect to the top surface 1050, or compensate for any geometrical default present on the top surface 1050 that could lead to a tilt of the pad structure platform 3000, and ultimately distribute the weight of the pad structure platform 3000 away from a central portion of the top surface 1050.

Accordingly, as shown by the depicted implementation of Figure 8, tilting plates 3152 may be installed on the positioning plate 3150 to locally adjust a distance between the frame 3100 and the top surface 1050 of the containment unit 1000. The tilting plates 3152 are configured to have a vertical thickness of approx. 1 mm to approx. 10 mm. The number of tilting plates 3152 implemented depends on the desired vertical displacement local height. The tilting plates 3152 may be installed through insertion, sliding, or wedging to the positioning plates 3150.

The pad structure platform 3000 further includes one or more fastening elements 3160 (one of which is shown on Figure 8) designed to securely attach the frame 3100 to containment unit 1000. For example, a fastening element 3160 may be provided in a vicinity of each corner of the frame 3100. The fastening element 3160 may comprise any suitable type of secure and removably attachable means, such as, for example, rotatable twist locking mechanisms, threaded bolts/nuts, *etc.* Upon installation of the frame 3100 onto the containment unit 1000, the fastening element 3160 is aligned with a complimentary aperture (not shown) and/or a positioning plate (not shown) of the top surface 1050 and rotated or screwed to lock into position with the complimentary aperture. In use, the positioning plates 3150 also allow accurate placement of the complimentary aperture that is designed to mate with the fastening element 3160.

Figure 9 shows an extended modular datacenter 50 including a plurality of containment unit 1000 in a side-by-side configuration, each containment unit 1000 being equipped with a corresponding air-to-liquid heat exchanger 2000 for cooling electronic devices disposed in the containment unit 1000. The air-to-liquid heat exchangers 2000 of the extended modular datacenter 50 are thus also disposed in a side-by-side such that the heat exchanger panels 2000 are parallel and face a same direction. In this implementation, the angled configuration of the heat exchangers 2000 enables an intake area of one of the air-to-liquid heat exchangers 2000 for pulling ambient air by fans thereof to be distinct from an exhaustion area of the at least one fan of a consecutive air-to-liquid heat exchanger.

It will be understood that, although the embodiments presented herein have been described with reference to specific features and structures, various modifications and combinations may be made without departing from the disclosure. The specification and drawings are, accordingly, to be regarded simply as an illustration of the discussed implementations or embodiments and their principles as defined by the appended claims, and are contemplated to cover any and all modifications, variations, combinations or equivalents that fall within the scope of the present disclosure.

## Claims

1. An air-to-liquid heat exchanger (2000) configured to be disposed on a support surface, the air-to-liquid heat exchanger (2000) comprising:
a frame (2100);
a heat exchanger panel (2200) mounted to the frame (2100), the heat exchanger panel (2200) being configured to circulate a channelized cooling liquid from a liquid inlet to a liquid outlet, the heat exchanger panel (2200) extending substantially orthogonally to the support surface; and
a fan assembly (2300) mounted to the frame (2100), the fan assembly (2300) comprising at least one fan (2310) configured to pull ambient air through the heat exchanger panel (2200), each of the at least one fan (2310) being rotatable about a rotation axis, the rotation axis extending substantially parallel to the support surface and at an angle with respect to a normal of the heat exchanger panel (2200).

2. The air-to-liquid heat exchanger (2000) of claim 1, wherein:
the frame (2100) defines a plurality of edges,
the at least one fan (2310) is disposed along a first one of the plurality of edges.

3. The air-to-liquid heat exchanger (2000) of claim 2, wherein the fan assembly (2300) further comprises an air deflector (2350) configured to convey the ambient air from the heat exchanger panel (2200) to the at least one fan (2310).

4. The air-to-liquid heat exchanger (2000) of claim 3, wherein the air deflector (2350) extends from a second one of the plurality of edges opposed to the first edge to the fan assembly (2300).

5. The air-to-liquid heat exchanger (2000) of any one of claims 1 to 4, wherein the angle is between 45° and 90°.

6. The air-to-liquid heat exchanger (2000) of claim 5, wherein the air deflector (2350) has a triangular shape.

7. The air-to-liquid heat exchanger (2000) of claim 6, wherein:
the angle is between 50° and 60°,
a ratio of a distance between the first and second edges over a length of the air deflector (2350) is between 1,1 and 1,2.

8. An air cooling assembly comprising:
a first air-to-liquid heat exchanger (2000) according to any one of claims 1 to 7; and
a second air-to-liquid heat exchanger (2000) according to any one of claims 1 to 7, the second air-to-liquid heat exchanger (2000) being disposed in a side-by-side configuration with the first air-to-liquid heat exchanger (2000) such that the heat exchanger panel (2200)s of the first and second air-to-liquid heat exchanger (2000)s are parallel and face a same direction,
wherein:
an intake area of the second air-to-liquid heat exchanger (2000) for pulling ambient air by the at least one fan (2310) thereof is distinct from an exhaustion area of the at least one fan (2310) of the first air-to-liquid heat exchanger (2000).

9. A modular datacenter (100) comprising:
a containment unit configured to house electronic devices;
a pad structure platform mounted on a top surface of the containment unit; and
an air-to-liquid heat exchanger (2000) according to any one of claims 1 to 7, mounted on the pad structure platform and configured to cool channelized cooling liquid by discharging thermal energy thereof into a vicinity of an outside of the containment unit, the pad structure platform being configured to permit circulation of a human operator along a circulation path, the circulation path extending along at least a portion of the fan assembly (2300) and at least a portion of the heat exchanger panel (2200) air-to-liquid heat exchanger (2000).

10. The modular datacenter (100) of claim 9, wherein:
the pad structure platform occupies a first surface area on the top surface of the containment unit, and
the air-to-liquid heat exchanger (2000) occupying a second surface area on the pad structure platform, a size the second surface being smaller than a size of the first surface area.

11. The modular datacenter (100) of claim 9 or 10, wherein the first surface area is smaller than a surface of the top surface.

12. The modular datacenter (100) of any one of claims 9 to 11, wherein the pad structure platform further comprises one or more sets of tilting plate members disposed therebelow, the tilting plate members of a same set being stacked upon one another being configured to raise a lateral side of the pad structure platform with respect to the top surface of the containment unit.

13. The modular datacenter (100) of claim 12, wherein the one or more sets of tilting plate members are disposed along longitudinal sides of the pad structure platform.

14. The modular datacenter (100) of any one of claims 9 to 13, wherein the containment unit is a first containment unit, the electronic devices are first electronic devices, the cooling loop is a first cooling loop, the pad structure platform is a first pad structure platform and the air-to-liquid heat exchanger (2000) is a first air-to-liquid heat exchanger (2000), the modular datacenter further comprising:
a second containment unit disposed next to the first containment unit, the second containment unit being configured to house second electronic devices;
a second cooling loop for cooling the second electronic devices, the cooling loop comprising cooling liquid units in thermal contact with the electronic devices for transferring thermal energy generated by the electronic devices to a channelized cooling liquid flowing in the cooling loop;
a second pad structure platform mounted on a top surface of the second containment unit, the second pad structure platform occupying a third surface area on the top surface of the second containment unit; and
a second air-to-liquid heat exchanger (2000) according to any one of claims 1 to 7, mounted on the second pad structure platform and configured to cool the channelized cooling liquid by discharging thermal energy thereof into a vicinity of an outside of the second containment unit, the second air-to-liquid heat exchanger (2000) occupying a fourth surface area on the second pad structure platform, a size the fourth surface being smaller than a size of the third surface area, the second pad structure platform being configured to permit circulation of a human operator around at least a portion of the second air-to-liquid heat exchanger (2000),
the first and second pad structure platforms being configured to enable passage of the human operator from the first pad structure platform to the second pad structure platform.

15. The modular datacenter (100) of claim 14, wherein the first and second pad structure platforms respectively include a first fence defining a first door and a second fence defining a second door, the first and second doors being, in use, aligned with one another to face one another, the first and second doors being selectively open or close to enable passage of the human operator.

## Amended claims

### Amended claims in accordance with Rule 137(2) EPC.

1. An air-to-liquid heat exchanger (2000) configured to be disposed on a support surface, the air-to-liquid heat exchanger (2000) comprising:
a frame (2100) defining a plurality of edges;
a heat exchanger panel (2200) mounted to the frame (2100), the heat exchanger panel (2200) being configured to circulate a channelized cooling liquid from a liquid inlet to a liquid outlet, the heat exchanger panel (2200) extending substantially orthogonally to the support surface having an air inlet side and an air outlet side; and
a fan assembly (2300) mounted to the frame (2100) along a first one of the plurality of edges, the fan assembly (2300) comprising at least one fan (2310) and an air deflector (2315),
wherein, the at least on fan (2310) is configured to pull ambient air through the heat exchanger panel (2200), each of the at least one fan (2310) being rotatable about a rotation axis that extends parallel to the support surface and at an angle with respect to a normal of the air inlet and outlet sides of the heat exchanger panel (2200) and
wherein, the air deflector (2315) manifests a triangular shape that extends from a second one of the plurality of edges opposed to the first edge and is configured to convey the ambient air from the heat exchanger panel (2200) to the at least one fan (2310).

2. The air-to-liquid heat exchanger (2000) of claim 1, wherein the angle is between 45° and 90°.

3. The air-to-liquid heat exchanger (2000) of claim 2, wherein:
the angle is between 50° and 60°,
a ratio of a distance between the first and second edges over a length of the air deflector (2350) is between 1,1 and 1,2.

4. An air cooling assembly comprising:
a first air-to-liquid heat exchanger (2000) according to any one of claims 1 to 3; and
a second air-to-liquid heat exchanger (2000) according to any one of claims 1 to 3, the second air-to-liquid heat exchanger (2000) being disposed in a side-by-side configuration with the first air-to-liquid heat exchanger (2000) such that the heat exchanger panel (2200) of the first and second air-to-liquid heat exchanger (2000) are parallel and face a same direction,
wherein:
an intake area of the second air-to-liquid heat exchanger (2000) for pulling ambient air by the at least one fan (2310) thereof is distinct from an exhaustion area of the at least one fan (2310) of the first air-to-liquid heat exchanger (2000).

5. A modular datacenter (100) comprising:
a containment unit configured to house electronic devices;
a pad structure platform mounted on a top surface of the containment unit; and
an air-to-liquid heat exchanger (2000) according to any one of claims 1 to 4, mounted on the pad structure platform and configured to cool channelized cooling liquid by discharging thermal energy thereof into a vicinity of an outside of the containment unit, the pad structure platform being configured to permit circulation of a human operator along a circulation path, the circulation path extending along at least a portion of the fan assembly (2300) and at least a portion of the heat exchanger panel (2200) air-to-liquid heat exchanger (2000).

6. The modular datacenter (100) of claim 5, wherein:
the pad structure platform occupies a first surface area on the top surface of the containment unit, and
the air-to-liquid heat exchanger (2000) occupying a second surface area on the pad structure platform, a size the second surface being smaller than a size of the first surface area.

7. The modular datacenter (100) of claim 5 or 6, wherein the first surface area is smaller than a surface of the top surface.

8. The modular datacenter (100) of any one of claims 5 to 7, wherein the pad structure platform further comprises one or more sets of tilting plate members disposed therebelow, the tilting plate members of a same set being stacked upon one another being configured to raise a lateral side of the pad structure platform with respect to the top surface of the containment unit.

9. The modular datacenter (100) of claim 8, wherein the one or more sets of tilting plate members are disposed along longitudinal sides of the pad structure platform.

10. The modular datacenter (100) of any one of claims 5 to 9, wherein the containment unit is a first containment unit, the electronic devices are first electronic devices, the cooling loop is a first cooling loop, the pad structure platform is a first pad structure platform and the
